# FASCICULE DE BREVET EUROPEEN

(11) **EP 0 317 440 B1**
(45) Date de publication et mention de la délivrance du brevet: **13.07.1994**
(21) Numéro de dépôt: 88402902.6
(22) Date de dépôt: 18.11.1988
(51) Int. Cl.: G01R 27/20, G01B 7/32, G01N 27/61, G01R 31/04

(54) **Dispositif de contrôle de brasure par mesure électronique de l'aire de la brasure**
Lötstellenprüfvorrichtung durch electronische Messung der Lötstellenfläche
Device for controling a soldering joint by electronic mesurement of the soldering joint area

(30) Priorité: 20.11.1987 FR 8716072
(43) Date de publication de la demande: 24.05.1989
(73) Titulaire: THOMSON-CSF, 75008 Paris (FR)
(72) Inventeur: Val, Christian, F-75008 Paris (FR)
(74) Mandataire: Benoit, Monique

(56) Documents cités:
- EP-A- 0 128 107
- DE-A- 3 445 213
- US-A- 4 507 605
- IBM TECHNICAL DISCLOSURE BULLETIN, vol. 29, no. 5, octobre 1986, pages 2121-2123, IBM Corp., New York, US; "Cross-sectional area determination by
- resistance measurement with compensation for temperature and contactresistance"
- IBM TECHNICAL DISCLOSURE BULLETIN, vol. 27, no. 4A, septembre 1984, pages 2024-2025, IBM Corp., New York, US; T. BAYER et al.: "Open/short testing"
- 1)Laser Inspect, 1985, pages 1 à 8, Vanzetti Systems Inc. 2)Hybrid Circuits, n 17, septembre 1988, pages 11 à 14, Vanzetti Systems Inc., Stoughton, US, "Eliminating Electronic Component Stresses through Controlled Laser Soldering", R. Vanzetti et A.C. Traub.

## Description

La présente invention a pour objet un dispositif de contrôle de brasure par mesure électronique de l'aire de la brasure, par exemple dans le domaine de la connectique.

La connexion par exemple de boîtiers ou de composants électroniques sur un substrat de circuit imprimé nécessite des soudures fiables, c'est-à-dire suffisamment larges et épaisses pour que soit établi un bon contact électrique et que ce dernier résiste dans le temps, aux variations de température et aux vibrations par exemple.

Cet aspect est d'autant plus important que l'environnement du circuit est sévère (applications militaires ou spatiales par exemple).

Différentes techniques de contrôle des connexions sont connues. Pour les applications à environnement sévère, on utilise principalement un contrôle visuel à l'aide éventuellement d'un microscope binoculaire. Cette technique présente l'inconvénient d'être longue et onéreuse, d'être limitée dans son efficacité et enfin de limiter la densité des circuits : en effet, les composants ou les boîtiers doivent être suffisamment éloignés les uns des autres pour permettre ce contrôle visuel et, de plus, toutes les brasures effectuées doivent être visibles, c'est-à-dire qu'elles doivent se situer à la périphérie des boîtiers ou des composants ; cela en augmente notablement l'encombrement lorsque le nombre de connexions devient important, ce qui est le cas notamment pour les circuits à très haut degré d'intégration.

La présente invention a pour objet un dispositif de contrôle de brasure par mesure électronique de l'aire de la brasure qui, applique à la connectique, permet de s'affranchir des limites précédentes, tel que défini par la revendication 1.

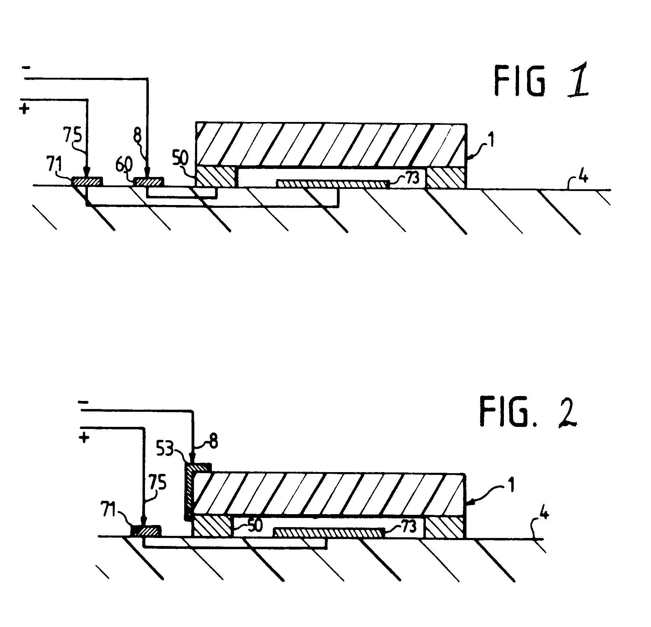

D'autres objets, caractéristiques et résultats de l'invention ressortiront de la description suivante, donnée à titre d'exemple et illustrée par les dessins annexés, qui représentent aux figures 1 et 2 différentes variantes de réalisation.

Sur ces différentes figures, d'une part les mêmes références se rapportent aux mêmes éléments et, d'autre part, l'échelle réelle n'a pas été respectée pour la clarté du dessin.

La figure 1 représente une variante du dispositif selon l'invention.

Sur cette figure, on a représenté schématiquement le boîtier 1 relié au substrat 4 par exemple par deux joints, dont l'un est repéré 50 et relié à un plot latéral 60.

Dans ce mode de réalisation, le substrat 4 porte une électrode 73 disposée de sorte à être placée sous le boitier 1, donc au voisinage du joint 50 à tester. Cette électrode 73 est reliée à un plot latéral 71 de manière analogue au joint 50. Le plot 60 est relié à un potentiei négatif et l'électrode 73, qui joue le même rôle que l'électrode 7 de la figure 1, est reliée par intermédiaire du plot 71 et d'une pointe 75 à un potentiel positif.

Le joint 50 émet alors des électrons et le courant mesuré entre le joint et l'électrode 73 est représentatif de la surface latérale du joint.

La pointe 8 est gainée par un isolant électrique par exemple du type manchon rétractable, pour éviter l'émission parasite d'électrons, sauf bien entendu à son extrémité. Dans une variante, le manchon peut avoir une taille telle qu'il entoure également le plot 60 lorsque la pointe 8 est appliquée sur ce dernier, diminuant encore l'émission parasite d'électrons.

Le fonctionnement du dispositif selon l'invention est le suivant.

Le joint 50 testé, relié par l'intermédiaire des éléments 60 et 8 à un potentiel négatif, constitue donc une cathode et émet des électrons, et ce de façon proportionnelle à sa surface émissive, à savoir sa surface latérale dans cet exemple. Les électrons ainsi émis pour partie sont capturés directement par l'électrode 73 jouant le rôle d'anode et, pour partie, ionisent les atomes du gaz situé le cas échéant entre le joint testé et l'anode 73 ; les électrons produits par l'ionisation sont également recueillis par l'anode 73. L'ensemble de ces électrons crée un courant fonction de l'aire latérale du joint 50 sous test, de la pression du gaz présent entre les électrodes 73 et 50, de la tension appliquée entre l'anode et la cathode et de la distance entre ces électrodes.

Il apparaît ainsi que la mesure du courant donne une mesure de la surface du joint sous test, les autres paramètres étant fixés. La mesure de la surface permet à son tour le contrôle de la qualité du joint de brasure : en effet, une surface trop grande ou trop petite, par rapport à des valeurs préalablement définies, indique respectivement une brasure trop étalée, avec risques éventuels de court circuit, ou au contraire une connexion insuffisante sur le plan électrique et/ou mécanique.

Dans une variante de réalisation, afin d'affiner la mesure du courant et de s'affranchir notamment des fluctuations de pression du gaz environnant, on mesure périodiquement le courant émis par une électrode supplémentaire (non représentée) servant d'étalon et dont l'aire est connue, de préférence voisine de celle du joint sous test.

Selon une autre variante de réalisation, on inverse périodiquement la polarité des tensions appliquées de sorte à utiliser périodiquement l'électrode 73 comme cathode ; la surface de l'électrode 73 étant connue, elle peut servir d'étalon : ce processus permet ainsi également de normaliser les mesures du courant. D'une manière plus générale, la tension appliquée entre cathode et anode peut être continue ou alternative.

Le dispositif selon l'invention permet également une mesure du volume d'un joint de brasure. Pour cela, on utilise le fait que le courant mesuré est fonction également de la tension et de la distance entre les électrodes et, fixant les autres paramètres, on fait varier la tension pour connaître la distance (moyenne) entre les électrodes. Connaissant la distance entre l'anode et le substrat (4), on en déduit l'épaisseur du joint et par suite son volume équivalent, sa surface latérale étant déjà connue. Cette mesure complémentaire est utile du fait que la qualité d'une brasure est liée à la quantité de matière reliant les deux parties.

La figure 2 représente une autre variante de réalisation, dans laquelle le potentiel négatif est appliqué sur le joint à tester par l'intermédiaire du boîtier.

Sur la figure 2, on retrouve le boîtier 1 connecté au substrat 4 par deux joints dont l'un, repéré 50, est sous test. A titre d'exemple, on a représenté l'électrode positive selon la même réalisation que la figure précédente, c'est-à-dire une électrode 73 disposée sur le substrat 4 sous le boîtier 1.

Dans cette variante, le boîtier comporte un plot supérieur 53 se prolongeant latéralement jusqu'au joint 50. La pointe 8 portée au potentiel négatif est alors placée sur le plot 53, portant ainsi le joint 50 à un potentiel négatif.

Le dispositif de contrôle selon l'invention permet de contrôler la qualité d'une brasure par mesure de sa surface latérale et de son volume équivalent, et ce que la brasure soit visible ou non, quelle que soit la forme (plane, développable ou gauche) de sa surface, et quelle que soit son application : brasure de boîtier (du type connu sous le nom de Pad Grid Array par exemple), de composant (du type connu sous le nom de "flip chip" par exemple), ou autre.

Ce contrôle peut s'effectuer par comparaison des valeurs obtenues pour chacun des joints à tester à une fourchette de valeurs de référence préétablies, ou encore par mesure successive de toutes les surfaces des brasures d'un même ensemble, détermination d'une moyenne et élimination des valeurs extrêmes.

Ce dispositif est également applicable, par exemple, au contrôle des motifs conducteurs déposés sur un substrat, par sérigraphie notamment.

Il est encore applicable, comme illustré sur la figure 10, au contrôle de motifs isolants.

Sur cette figure, on a représenté un substrat isolant 90 sur lequel a été déposé un motif isolant 91 dont on souhaite contrôler l'aire. A cet effet, on dispose sur l'autre face du substrat 90 un motif conducteur 93 de surface voisine de celle du motif 91, qu'on porte à un potentiel négatif à l'aide d'une pointe 94. Au dessus du motif 91, on dispose une électrode 92 reliée à un potentiel négatif.

La fonction du motif conducteur 93 est de permettre de porter la surface du motif isolant 91 à un potentiel négatif. La différence de potentiel appliquée aux électrodes 92 et 93 est continue ou alternative. Le fonctionnement du dispositif est alors analogue à ce qui est décrit précédemment.

## Revendications

1. Dispositif de contrôle de brasure par mesure électronique de l'aire de la brasure, caractérisé par le fait que, la brasure formant joint (50) entre un boîtier (1) de composant électronique et un substrat (4) d'interconnexion, le dispositif comporte une électrode (73) disposée sur le substrat, sous le boîtier, électriquement reliée à un premier plot (71) disposé sur le substrat à la périphérie du boîtier, le premier plot étant porté à un premier potentiel ; que le joint (50) est électriquement relié à un deuxième plot (60, 53), disposé également à la périphérie du boîtier, et qu'il comporte en outre des moyens pour porter le deuxième plot et, par suite, le joint à un potentiel négatif par rapport au premier potentiel, de sorte que le joint émette des électrons dont le nombre est fonction de l'étendue de la surface, et des moyens de mesure du courant entre la surface et l'électrode, le courant étant représentatif du nombre d'électrons et par suite de l'étendue de la surface.

2. Dispositif selon la revendication 1, caractérisé par le fait que le deuxième plot (53) est disposé sur le côté du boîtier (1), en contact électrique avec le joint (50).

3. Dispositif selon la revendication 1, caractérisé par le fait que le deuxième plot (60) est disposé sur le substrat (4).

## Claims

1. Device for inspection of soldering by electronic measurement of the area of the soldering, characterized in that, with the soldering forming a joint (50) between an electronic component package (1) and an interconnection substrate (4), the device includes an electrode (73) arranged on the substrate, beneath the package, and electrically connected to a first contact pad (71) arranged on the substrate at the periphery of the package, the first contact pad being raised to a first potential; in that the joint (50) is electrically connected to a second contact pad (60, 53) also arranged at the periphery of the package, and in that it furthermore includes means for raising the second contact pad, and consequently the joint, to a negative potential with respect to the first potential, so that the joint emits electrons whose number is a function of the area of the surface, and means for measuring the current between the surface and the electrode, the current being representative of the number of electrons and consequently of the area of the surface.

2. Device according to Claim 1, characterized in that the second contact pad (53) is arranged on the side of the package (1), in electrical contact with the joint (50).

3. Device according to Claim 1, characterized in that the second contact pad (60) is arranged on the substrate (4).

## Patentansprüche

1. Vorrichtung zur Lötstellenprüfung durch elektronische Messung der Lötstellenfläche, gekennzeichnet durch die Tatsache, daß das Löten eine Verbindung (50) zwischen einem Gehäuse (1) eines elektronischen Bauelements und einem Verbindungssubstrat (4) bildet, wobei die Vorrichtung eine unterhalb des Gehäuses auf dem Substrat angeordnete Elektrode (73) aufweist, die elektrisch mit einer auf dem Substrat am Rand des Gehäuses angebrachten ersten Kontaktstelle (71) verbunden ist, wobei die erste Kontaktstelle an ein erstes Potential gelegt ist, daß die Verbindung (50) elektrisch an eine zweite Kontaktstelle (60, 53) angeschlossen ist, die ebenfalls am Rand des Gehäuses angeordnet ist, und daß sie ferner Mittel enthält, um die zweite Kontaktstelle und folglich die Verbindung auf ein gegenüber dem ersten Potential negatives Potential zu legen, so daß die Verbindung Elektronen abgibt, deren Zahl von der Ausdehnung der Fläche abhängt, und Mittel zum Messen des Stroms zwischen der Fläche und der Elektrode enthält, wobei der Strom die Anzahl der Elektroden und folglich die Ausdehnung der Fläche repräsentiert.

2. Vorrichtung nach Anspruch 1, gekennzeichnet durch die Tatsache, daß die zweite Kontaktstelle (53) auf der Seite des Gehäuses (1) in elektrischem Kontakt mit der Verbindung (50) angeordnet ist.

3. Vorrichtung nach Anspruch 1, dadurch gekennzeichnet, daß die zweite Kontaktstelle (60) auf dem Substrat (4) angebracht ist.
